# EUROPEAN PATENT APPLICATION

(11) **EP 4 589 375 A1**
(43) Date of publication of application: **23.07.2025**
(21) Application number: 23925641.5
(22) Date of filing: 03.03.2023
(51) Int. Cl.: G02F 1/1335, G02F 1/1362

(54) **ARRAY SUBSTRATE AND DISPLAY APPARATUS**

(71) Applicant: Boe Technology Group Co., Ltd., Beijing 100015 (CN); Beijing BOE Display Technology Co., Ltd., Beijing 100176 (CN)
(72) Inventor: XIAO, Junying, Beijing 100176 (CN); TIAN, Xiaohan, Beijing 100176 (CN); QIN, Wei, Beijing 100176 (CN); HUANG, Jianhua, Beijing 100176 (CN); QU, Yingying, Beijing 100176 (CN); MIAO, Yingmeng, Beijing 100176 (CN); CHEN, Dongchuan, Beijing 100176 (CN); LIAO, Yanping, Beijing 100176 (CN); LEE, Seungmin, Beijing 100176 (CN); LI, Hui, Beijing 100176 (CN)
(74) Representative: Brötz, Helmut
(86) International application number: PCT/CN2023/079449
(87) International publication number: WO 2024/182913

(57) **Abstract**

The present disclosure provides an array substrate and a display apparatus. The array substrate comprises a base substrate, and multiple sub-pixels located on the base substrate. The sub-pixels are arranged in an array along a first direction and a second direction, the first direction intersecting with the second direction. The array substrate comprises multiple pixel regions, each pixel region comprising sub-pixels of different colors arranged along the first direction, and different pixel regions having the same area. In the same pixel region, the dimensions of the sub-pixel regions of at least two sub-pixels of different colors in the first direction are different, the ratio of the dimensions of the sub-pixel regions of at least two sub-pixels having different colors in the first direction being 1-2. A sub-pixel region comprises an effective light-emitting region. **In** the array substrate provided in the present disclosure, by means of configuring the ratio of the dimensions of the sub-pixel regions of sub-pixels having different colors in the first direction, emergent light can satisfy a required white balance without ACC debugging, such that transmittance can be increased by at least 10% when the array substrate is used in a display apparatus.

## Description

### TECHNICAL FIELD

Embodiments of the present disclosure relate to an array substrate and a display apparatus.

### BACKGROUND

At present, liquid crystal display apparatuses are widely used in people's lives. Large-sized liquid crystal television products have increasingly high requirements for display characteristics such as resolution, white balance, and transmittance.

### SUMMARY

Embodiments of the present disclosure provide a display substrate and a display apparatus.

An embodiment of the present disclosure provides an array substrate, which includes: a base substrate; a plurality of sub-pixels, located on the base substrate and arranged in an array along a first direction and a second direction; the first direction and the second direction intersecting with each other. The array substrate includes a plurality of pixel regions, each pixel region includes sub-pixels with different colors arranged along the first direction, and different pixel regions have a same area; in a same pixel region, sub-pixel regions of at least two sub-pixels with different colors have different sizes in the first direction; a size ratio of the sub-pixel regions of the at least two sub-pixels with different colors in the first direction ranges from 1 to 2; and the sub-pixel region includes an effective light-exiting region.

For example, according to an embodiment of the present disclosure, the array substrate further includes: a plurality of data lines, arranged along the first direction; and a plurality of gate lines, arranged along the second direction. The plurality of data lines and the plurality of gate lines intersect with each other to surround effective light-exiting regions of the plurality of sub-pixels.

For example, according to an embodiment of the present disclosure, respective sub-pixels each include a pixel electrode and a common electrode stacked; and in a same pixel region, pixel electrodes of the at least two sub-pixels with different colors have different sizes in the first direction.

For example, according to an embodiment of the present disclosure, the plurality of data lines is unevenly distributed in the first direction, and the plurality of gate lines is evenly distributed in the second direction.

For example, according to an embodiment of the present disclosure, a size ratio of pixel electrodes of the at least two sub-pixels with different colors in the first direction is not greater than 2.

For example, according to an embodiment of the present disclosure, in a same pixel region, a size ratio of sub-pixel regions of the at least two sub-pixels with different colors in the second direction ranges from 0.9 to 1.1.

For example, according to an embodiment of the present disclosure, each pixel region includes a first color sub-pixel, a second color sub-pixel, and a third color sub-pixel; and in a same pixel region, a sub-pixel region of the second color sub-pixel has the largest size in the first direction.

For example, according to an embodiment of the present disclosure, the pixel electrode of the second color sub-pixel has the largest size in the first direction.

For example, according to an embodiment of the present disclosure, in a same pixel region, a size ratio of a sub-pixel region of the first color sub-pixel to a sub-pixel region of the third color sub-pixel in the first direction ranges from 0.9 to 1.1.

For example, according to an embodiment of the present disclosure, in a same pixel region, a size ratio of the pixel electrode of the first color sub-pixel to the pixel electrode of the third color sub-pixel in the first direction ranges from 0.9 to 1.1.

For example, according to an embodiment of the present disclosure, respective sub-pixels each further include a transistor; and a first electrode of the transistor is connected with a pixel electrode; the array substrate further includes a common electrode line electrically connected with a common electrode; in a direction perpendicular to the base substrate, the first electrode of the transistor of each sub-pixel overlaps with the common electrode line; and an overlapping area between the first electrode of the transistor of the second color sub-pixel and the common electrode line is smaller than an overlapping area between the first electrode of the transistor of a sub-pixel with other color and the common electrode line.

For example, according to an embodiment of the present disclosure, in a same pixel region, a ratio of charge pull-down voltages δVp of any two sub-pixels with different colors ranges from 0.9 to 1.1; δVp=[Cgs/(Cgs+Cst+Clc)]*(Vgh-Vgl), where, Cgs is a capacitor between the first electrode and a gate electrode of the transistor, Cst is a storage capacitor of a sub-pixel, Clc is a liquid crystal capacitor, Vgh is a potential at which a gate line potential is boosted to a high level, and Vgl is a potential at which a gate line potential is bucked to a low level.

For example, according to an embodiment of the present disclosure, a first portion in the common electrode line that overlaps with the first electrode of the transistor extends along the second direction; and a size of an overlapping portion between the first electrode of the transistor of the second color sub-pixel and the first portion in the second direction is smaller than a size of an overlapping portion between the first electrode of the transistor of the sub-pixel with other color and the first portion in the second direction.

For example, according to an embodiment of the present disclosure, the first portion of the common electrode line is alternately arranged with the data line along the first direction; the first electrode of the transistor is arranged in the same layer as the data line; and the first portion is arranged in the same layer as the pixel electrode.

For example, according to an embodiment of the present disclosure, the plurality of sub-pixels is arranged into a plurality of rows and columns of sub-pixels; sub-pixels located in a same row are arranged in the first direction, while sub-pixels located in a same column are arranged in the second direction; two gate lines are arranged between two adjacent rows of sub-pixels; and two columns of sub-pixels are arranged between two adjacent data lines; a second portion of the common electrode line that is arranged between the two columns of sub-pixels is arranged in the same layer as the gate line; and the first portion of the common electrode line overlaps with the gate line.

For example, according to an embodiment of the present disclosure, two gate lines constitute a gate line pair; the plurality of gate lines includes a plurality of gate line pairs; and the plurality of gate line pairs is evenly distributed in the second direction.

For example, according to an embodiment of the present disclosure, each pixel region includes a first color sub-pixel, a second color sub-pixel, and a third color sub-pixel; and in a same pixel region, the pixel electrode of the first color sub-pixel has the largest size in the first direction.

For example, according to an embodiment of the present disclosure, in the first direction, a size of the pixel electrode of the second color sub-pixel is larger than a size of the pixel electrode of the third color sub-pixel; a difference between the pixel electrode of the first color sub-pixel and the pixel electrode of the second color sub-pixel is a first difference; a difference between the pixel electrode of the second color sub-pixel and the pixel electrode of the third color sub-pixel is a second difference; and a ratio of the first difference to the second difference ranges from 0.9 to 1.1.

For example, according to an embodiment of the present disclosure, the plurality of sub-pixels is arranged into a plurality of rows and columns of sub-pixels; sub-pixels located in a same row are arranged in the first direction, while sub-pixels located in a same column are arranged in the second direction; one gate line is arranged between two adjacent rows of sub-pixels, and one data line is arranged between two adjacent columns of sub-pixels.

For example, according to an embodiment of the present disclosure, the first color sub-pixel is a red color sub-pixel, the second color sub-pixel is a green sub-pixel, and the third color sub-pixel is a blue sub-pixel.

Another embodiment of the present disclosure provides a display apparatus, which includes the array substrate as mentioned above; an opposite substrate, arranged opposite to the array substrate, the opposite substrate including a color filter; a liquid crystal layer, located between the array substrate and the opposite substrate; and a backlight source, located on a side of the array substrate away from the liquid crystal layer. A size ratio of sub-pixel regions of the at least two sub-pixels with different colors in the pixel region in the first direction ranges from 1 to 2, so that white light emitted by the display apparatus meets preset white balance coordinates without performing accurate color capture adjustment on the display apparatus.

For example, according to an embodiment of the present disclosure, the backlight source includes a quantum dot material or a fluorescent material.

For example, according to an embodiment of the present disclosure, the backlight source includes a quantum dot material; a spectrum of the backlight source includes a red light peak, a green light peak and a blue light peak; and a peak value of the red light peak is higher than a peak value of the green light peak.

For example, according to an embodiment of the present disclosure, a ratio of a peak value of the blue light peak to the peak value of the red light peak ranges from 1.8 to 2.8.

For example, according to an embodiment of the present disclosure, the backlight source includes a fluorescent material; and a spectrum of the backlight source includes a red light peak, a green light peak, and a blue light peak; a ratio of a peak value of the blue light peak to a peak value of the red light peak ranges from 0.7 to 0.9; and a ratio of a peak value of the green light peak to the peak value of the red light peak ranges from 0.15 to 0.28.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
FIG. 1 is a schematic diagram of a partial structure of an array substrate provided by an embodiment of the present disclosure.
FIG. 2 is a schematic diagram of some sub-pixels and signal lines in an example shown in FIG. 1.
FIG. 3 is a schematic diagram of a partial structure of the sub-pixels and the signal lines shown in FIG. 2.
FIG. 4 is a schematic diagram of a partial structure of some sub-pixels and signal lines in another example shown in FIG. 1.
FIG. 5 is a schematic diagram of a partial structure of the sub-pixels and the signal lines shown in FIG. 4.
FIG. 6 is a comparison diagram between a spectrum of a backlight source adopted when the array substrate shown in FIG. 2 is applied to a display apparatus and a spectrum of a backlight source adopted when the array substrate shown in FIG. 4 is applied to a display apparatus.
FIG. 7 is a spectrogram of another backlight source.
FIG. 8 is a comparison diagram between spectrums of different color filters.
FIG. 9 is a schematic diagram of a partial structure of an array substrate provided by another example of the embodiment of the present disclosure.
FIG. 10 is a schematic diagram of the sub-pixels shown in FIG. 9 before adjusting a size of a sub-pixel region.
FIG. 11 is a schematic diagram of the sub-pixels shown in FIG. 9 after adjusting a size of the sub-pixel region.
FIG. 12 is a schematic diagram of a partial structure of a display apparatus provided by another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "substantially the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two. The "same layer" in the present disclosure refers to the structure formed by two (or more) structures formed by the same deposition process and patterned by the same patterning process, and their materials may be the same or different. The "integrated structure" in the present disclosure refers to two (or more) structures which are formed by the same deposition process and patterned by the same patterning process, and their materials may be the same or different.

In the study, an inventor of the present application found that as requirements of television (TV) products for resolution become increasingly high, transmittance of the products faces significant challenges. Taking a display apparatus having an 8K resolution and a 65-inch screen as an example, considering that significant differences between aperture ratios of a red sub-pixel, a green sub-pixel, and a blue sub-pixel occur after a photo spacer (PS) is arranged around sub-pixels of one or two colors, accurate color capture (ACC) adjustment is performed on a display panel, but thereafter, transmittance (Tr) loss is significant. For example, in pixel structure design of the above-described 8K-resolution product, sub-pixel regions (i.e., dots) where the red sub-pixel, the green sub-pixel and the blue sub-pixel are respectively located have the same size in a row direction; original aperture ratios of the respective sub-pixels may be each defined as a ratio of an area of an effective light-exiting region to an area of a sub-pixel region; setting of the original aperture ratios of the respective sub-pixels cannot perfectly match characteristics of a color filter and a backlight, so the display panel has to undergo ACC adjustment so as to meet preset white balance coordinates, for example, specific values (x=0.28, y=0.29), but at this time, transmittance loss is significant. In addition, because of limitations of specification parameters such color gamut, certain high-transmittance color filters cannot be used in the above-described pixel structure in which the respective sub-pixel regions have a same size in the row direction, which limits improvement in transmittance of the display panel.

In order to make different grayscales have same color performance, ACC adjustment is needed to make color distribution more even. ACC is intended to correct color temperature according to requirements, so that an image is more natural. Usually, a panel firstly undergoes Gamma curve adjustment and then ACC adjustment, to more finely adjust color coordinates and the Gamma curve, so that a proportion of sub-pixels with colors of red, green and blue (RGB) at different grayscales makes the color temperature and the Gamma curve meet requirements.

The present disclosure provides an array substrate and a display apparatus. The array substrate includes a base substrate and a plurality of sub-pixels located on the base substrate. The plurality of sub-pixels is arranged in an array along a first direction and a second direction; and the first direction and the second direction intersect with each other. The array substrate includes a plurality of pixel regions; each pixel region includes sub-pixels with different colors arranged along the first direction, and different pixel regions have a same area; in a same pixel region, sub-pixel regions of at least two sub-pixels with different colors have different sizes in the first direction; a size ratio of sub-pixel regions of at least two sub-pixels with different colors in the first direction is 1 to 2; and a sub-pixel region includes an effective light-exiting region. In the array substrate provided by the present disclosure, by setting a size ratio of sub-pixel regions of sub-pixels with different colors in the first direction, the display apparatus including the array substrate may have emergent light meet white balance requirements without ACC adjustment, so that transmittance may be improved by at least 10% when the array substrate is applied to the display apparatus.

Hereinafter, the array substrate and the display apparatus provided by the embodiments of the present disclosure will be described in conjunction with the accompanying drawings.

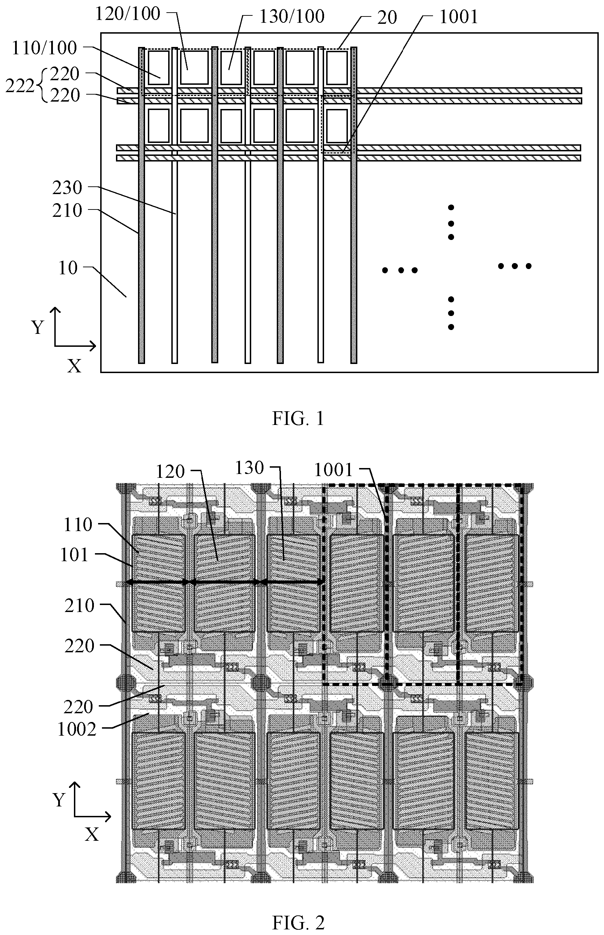

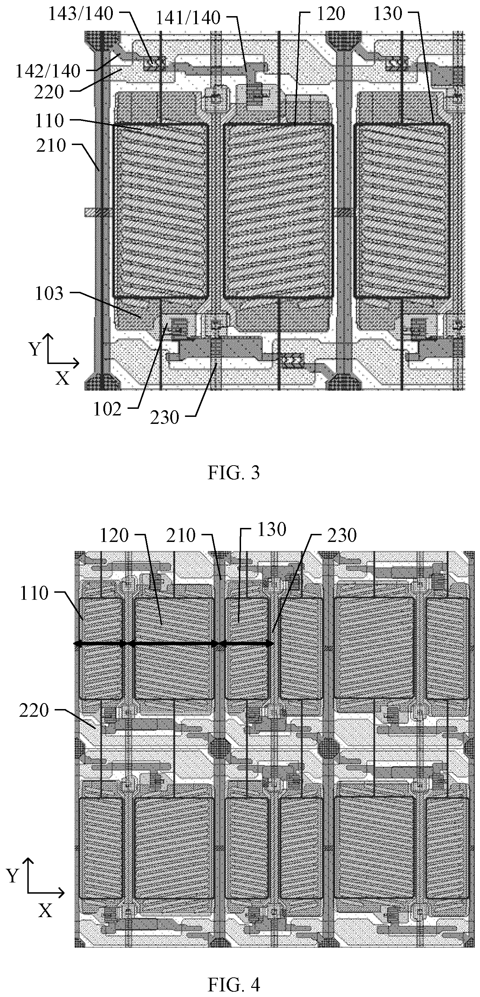

FIG. 1 is a schematic diagram of a partial structure of an array substrate provided by an embodiment of the present disclosure. FIG. 2 is a schematic diagram of some sub-pixels and signal lines in an example shown in FIG. 1. FIG. 3 is a schematic diagram of a partial structure of the sub-pixels and the signal lines shown in FIG. 2.

As shown in FIG. 1 to FIG. 3, the array substrate includes a base substrate 10 and a plurality of sub-pixels 100 located on the base substrate 10. The plurality of sub-pixels 100 is arranged in an array along a first direction and a second direction; and the first direction and the second direction intersect with each other. For example, the first direction may be an X direction shown in FIG. 1; the second direction may be a Y direction shown in FIG. 1; and the first direction and the second direction may be interchanged. For example, an included angle between the first direction and the second direction may be 80 degrees to 100 degrees. For example, the included angle between the first direction and the second direction may be 85 degrees to 95 degrees. For example, the first direction is perpendicular to the second direction. For example, the first direction may be a row direction; and the second direction may be a column direction.

For example, a region where the plurality of sub-pixels 100 is located may be a display region used for displaying images in the array substrate; and the array substrate further includes a peripheral region surrounding the display region.

As shown in FIG. 1 to FIG. 3, the array substrate includes a plurality of pixel regions 20; each pixel region includes sub-pixels 100 with different colors arranged along the first direction; and different pixel regions 20 have a same area. For example, the plurality of pixel regions 20 may be arranged in an array along the first direction and the second direction. For example, different pixel regions 20 include the same number of sub-pixels 100, for example, three sub-pixels 100 with different colors. For example, a region where each sub-pixel 100 is located may be a sub-pixel region 1001, that is, a dot; each pixel region 20 includes a plurality of sub-pixel regions 1001, for example, an area of each pixel region 20 may be a sum of areas of a plurality of sub-pixel regions 1001 included thereby; and an area of a pixel region 20 may be set to a certain value. For example, a total pixel aperture ratio of a pixel region 20 may be a ratio of the sum of areas of effective light-exiting regions of sub-pixels 100 to an area of the pixel region 20; and pixel aperture ratios of the respective sub-pixels 100 may be a ratio of an area of an effective light-exiting region 101 of each sub-pixel 100 to the area of the pixel region 20. Definition of the pixel aperture ratio here is different from definition of the foregoing original aperture ratio. The above-described effective light-exiting region 101 may be a region shown by a black box in FIG. 2, and a region outside the effective light-exiting region 101 is provided with a black matrix 1002. The sub-pixel region 1001 includes an effective light-exiting region 101 and a non-light-exiting region surrounding the effective light-exiting region 101; the non-light-exiting region directly faces the black matrix. The above-described effective light-exiting region refers to an opening region of the sub-pixel; and light may pass through the opening region of the sub-pixel.

As shown in FIG. 1 to FIG. 3, in a same pixel region 20, sub-pixel regions 1001 of at least two sub-pixels 100 with different colors have different sizes in the first direction; and a size ratio of sub-pixel regions 1001 of at least two sub-pixels 100 with different colors in the first direction is 1 to 2. For example, the size ratio of sub-pixel regions 1001 of at least two sub-pixels 100 with different colors in the first direction is 1.01 to 1.99, or 1.1 to 1.7, or 1.2 to 1.9, or 1.3 to 1.5, or 1.4 to 1.8, etc.

For example, as shown in FIG. 1 to FIG. 3, in a same pixel region 20, effective light-exiting regions 101 of at least two sub-pixels 100 with different colors have different sizes in the first direction; and a size ratio of effective light-exiting regions 101 of at least two sub-pixels 100 with different colors in the first direction is 1 to 2. For example, the size ratio of effective light-exiting regions 101 of at least two sub-pixels 100 with different colors in the first direction is 1.01 to 1.99, or 1.1 to 1.7, or 1.2 to 1.9, or 1.3 to 1.5, or 1.4 to 1.8, etc.

For example, in a case where sub-pixel regions of sub-pixels with different colors all have the same size in the first direction, setting of pixel aperture ratios of sub-pixels with respective colors cannot perfectly match characteristics of a color filter and a backlight, so white dot coordinates (x, y) do not match preset white balance coordinates (x=0.28, y=0.29). Therefore, ACC adjustment needs to be performed on a display panel to adjust the above-described white dot coordinates, so that the white dot coordinates meet the preset white balance coordinates (Spec); however, such process will reduce transmittance of the display panel. Through simulation, it may be observed that where exists a certain regularity between changes in the white dot coordinates (x, y) and a pixel aperture ratio of a red sub-pixel, a pixel aperture ratio of a green sub-pixel, and a pixel aperture ratio of a blue sub-pixel, which is as follows: (1) assuming that the pixel aperture ratio of the blue sub-pixel decreases, the white dot coordinates (x, y) both increase; assuming that the pixel aperture ratio of the blue sub-pixel increases, the white dot coordinates (x, y) both decrease; (2) assuming that the pixel aperture ratio of the green sub-pixel decreases, y decreases significantly while x decreases slightly; assuming that the pixel aperture ratio of the green sub-pixel increases, y increases significantly while x increases slightly; (3) assuming that the pixel aperture ratio of the red sub-pixel decreases, x decreases significantly while y decreases slightly; assuming that the pixel aperture ratio of the red sub-pixel increases, x increases significantly while y increases slightly. According to the regularity, by keeping a total pixel aperture ratio unchanged and lengths of different sub-pixel regions (e.g., sizes of the sub-pixel regions in a column direction) unchanged, and by changing widths of different sub-pixel regions (e.g., sizes of the sub-pixel regions in a row direction) for sub-pixel region width differentiation design to make width ratios of different sub-pixel regions between 1 to 2, for example, reallocating respective pixel aperture ratios of the red sub-pixel, the green sub-pixel and the blue sub-pixel according to the characteristics of the backlight and the color filter to perfectly match any color filter and backlight solution, the white dot coordinates may be adjusted to the Spec value without ACC adjustment, which is favorable for maximizing transmittance, for example, improving transmittance by 10%.

As compared with the case where sub-pixel regions of sub-pixels with different colors all have a same size in the first direction, the present disclosure, by setting sub-pixel regions of sub-pixels with different colors to different sizes ranging from 1 to 2 in the first direction, allows the array substrate to have emergent light meet required white balance without ACC adjustment, so that transmittance may be improved by at least 10% when the array substrate is applied to the display apparatus. The array substrate may effectively solve the problem of significant transmittance loss of 8k-resolution television products after ACC adjustment performed on panels thereof.

In some examples, as shown in FIG. 1 to FIG. 3, the array substrate further includes a plurality of data lines 210 arranged along the first direction and a plurality of gate lines 220 arranged along the second direction. The plurality of data lines 210 and the plurality of gate lines 220 intersect with each other to surround the effective light-exiting regions 101 of the plurality of sub-pixels 100.

In some examples, as shown in FIG. 1 to FIG. 3, the plurality of sub-pixels 100 is arranged into a plurality of rows and columns of sub-pixels 100; sub-pixels 100 located in the same row are arranged in the first direction, while sub-pixels 100 located in the same column are arranged in the second direction; two gate lines 220 are arranged between two adjacent rows of sub-pixels 100, and two columns of sub-pixels 100 are arranged between two adjacent data lines 210.

In some examples, as shown in FIG. 1 to FIG. 3, two gate lines 220 constitute a gate line pair 222; and the plurality of gate lines 220 includes a plurality of gate line pairs 222.

In some examples, as shown in FIG. 1 to FIG. 3, the respective sub-pixels 100 include a pixel electrode 102 and a common electrode 103 stacked. For example, one of the pixel electrode 102 and the common electrode 103 may be a plate-shaped electrode, while the other may include a slit electrode, for example, include a plurality of strip electrodes.

In some examples, as shown in FIG. 1 to FIG. 3, the array substrate further includes a common electrode line 230 electrically connected with the common electrode 103. For example, the array substrate includes a plurality of common electrode lines 230; and the plurality of common electrode lines 230 and the plurality of data lines 210 is alternately arranged along the first direction.

For example, as shown in FIG. 1 to FIG. 3, the sub-pixel regions of the above-described respective sub-pixels 100 may be regions surrounded by centerlines of common electrode lines 230, centerlines of data lines 210, and centerlines of gate line pairs 222.

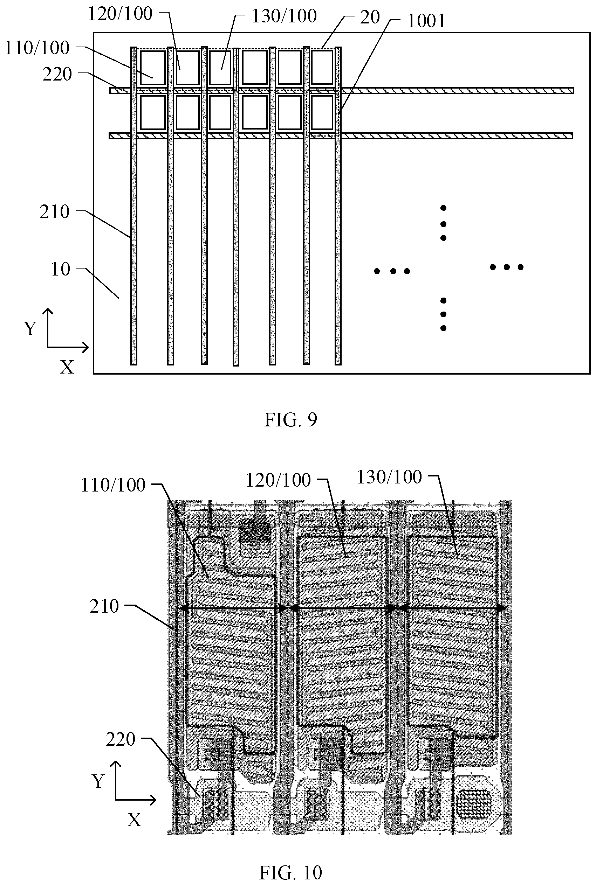

The above-described definitions are described by taking a dual gate structure as an example, but are not limited thereto; and with respect to a single gate structure (as shown in FIG. 9), the sub-pixel regions of the above-described respective sub-pixels may be regions surrounded by centerline of data lines and centerlines of gate lines.

The data lines, the common electrode lines and the gate lines as described above are referred to as signal lines; in the case where the signal line is a straight line, the centerline is a centerline of the signal line; in the case where the signal line is a curved line, the centerline may be a line passing through midpoints of lines connecting two edges just sandwiching the curved line with a maximum distance from each other, the two edges extend along an overall extension direction of the curved line.

In some examples, as shown in FIG. 1 to FIG. 3, the plurality of data lines 210 is unevenly distributed in the first direction; and the plurality of gate line pairs 222 are evenly distributed in the second direction. For example, the plurality of common electrode lines 230 are unevenly distributed in the first direction. By setting positional relationships between the data lines, the common electrode lines and the gate line pairs, sizes of the sub-pixel regions of the sub-pixels in the respective pixel regions may be adjusted.

In some examples, as shown in FIG. 1 to FIG. 3, in a same pixel region 20, a size ratio of sub-pixel regions 1001 of at least two sub-pixels 100 with different colors in the second direction is 0.9 to 1.1. For example, sub-pixel regions 1001 of sub-pixels 100 with different colors may have the same size in the second direction.

For example, size and resolution of a display screen determine that sizes in the first direction and sizes in the second direction are all fixed values for the respective pixel regions 20. Because the pixel region 20 has only one sub-pixel 100 arranged in the second direction, and the pixel region 20 has a plurality of sub-pixels 100 arranged in the first direction, a size of the sub-pixel region of the sub-pixel 100 in the second direction remains unchanged; and by adjusting sizes of different sub-pixel regions in the first direction, the emergent light may meet required white balance without ACC adjustment, so as to improve transmittance when the array substrate is applied to the display apparatus.

In some examples, as shown in FIG. 1 to FIG. 3, in a same pixel region 20, pixel electrodes 102 of at least two sub-pixels 100 with different colors have different sizes in the first direction, to adapt to different sizes of different sub-pixel regions in the first direction.

In some examples, as shown in FIG. 1 to FIG. 3, in a same pixel region 20, a size ratio of pixel electrodes 102 of at least two sub-pixels 100 with different colors in the first direction is not greater than 2. For example, the size ratio of pixel electrodes 102 of at least two sub-pixels 100 with different colors in the first direction may be 1.01 to 1.99, or 1.1 to 1.5, or 1.2 to 1.9, or 1.3 to 1.7, or 1.4 to 1.8, etc. For example, the size ratio of pixel electrodes 102 of sub-pixels 100 with different colors in the first direction and a size ratio of sub-pixel regions 1001 where the sub-pixels 100 with different colors are located in the first direction may be the same or different. Assuming that the two are different, a ratio of a difference between the two to one of the two is not greater than 10%.

In some examples, as shown in FIG. 1 to FIG. 3, each pixel region 20 includes a first color sub-pixel 110, a second color sub-pixel 120, and a third color sub-pixel 130; in a same pixel region 20, the sub-pixel region 1001 of the second color sub-pixel 120 has the largest size in the first direction. For example, an effective light-exiting region 101 of the second color sub-pixel 120 has the largest size in the first direction.

The second color sub-pixel may be a sub-pixel having the greatest impact on transmittance of the array substrate. By setting an area of the sub-pixel region of the second color sub-pixel to be larger than an area of the sub-pixel region of the sub-pixel with other color, it is favorable for improving transmittance of the array substrate.

For example, as shown in FIG. 1 to FIG. 3, the second color sub-pixel 120 has the highest pixel aperture ratio.

In some examples, as shown in FIG. 1 to FIG. 3, the pixel electrode 102 of the second color sub-pixel 120 has the largest size in the first direction.

As compared with a case where sub-pixel regions of sub-pixels with respective colors all have the same size (e.g., width) in the first direction, in the array substrate provided by the present disclosure, sizes of sub-pixel regions in the first direction are set to be different, by setting widths of sub-pixel regions of the first color sub-pixel and the third color sub-pixel to be smaller while setting a width of the sub-pixel region of the second color sub-pixel to be larger, the emergent light may meet required white balance without ACC adjustment, so as to improve transmittance when the array substrate is applied to the display apparatus.

In some examples, as shown in FIG. 1 to FIG. 3, in a same pixel region 20, a size ratio of the sub-pixel region 1001 of the first color sub-pixel 110 to the sub-pixel region 1001 of the third color sub-pixel 130 in the first direction is 0.9 to 1.1. For example, the sub-pixel region 1001 of the first color sub-pixel 110 and the sub-pixel region 1001 of the third color sub-pixel 130 may have the same size in the first direction, which facilitates subsequent adjustment and compensation for charge pull-down voltage.

For example, as shown in FIG. 2, a size ratio of the sub-pixel region 1001 of the second color sub-pixel 120 to the sub-pixel region 1001 of the first color sub-pixel 110 in the first direction may be 1.13.

In some examples, as shown in FIG. 1 to FIG. 3, in a same pixel region 20, a size ratio of the pixel electrode 102 of the first color sub-pixel 110 to the pixel electrode 102 of the third color sub-pixel 130 in the first direction is 0.9 to 1.1. For example, the pixel electrode 102 of the first color sub-pixel 110 and the pixel electrode 102 of the third color sub-pixel 130 may have the same size in the first direction.

For example, as shown in FIG. 1 to FIG. 3, in a same pixel region 20, a size ratio of the sub-pixel region of the first color sub-pixel 110 to an effective light-exiting region of the third color sub-pixel 130 in the first direction is 0.9 to 1.1. For example, in a same pixel region 20, the sub-pixel region of the first color sub-pixel 110 and an effective light-exiting region of the third color sub-pixel 130 have the same size in the first direction.

In some examples, as shown in FIG. 1 to FIG. 3, the first color sub-pixel 110 is a red sub-pixel, the second color sub-pixel 120 is a green sub-pixel, and the third color sub-pixel 130 is a blue sub-pixel. Of course, the embodiments of the present disclosure are not limited thereto; and colors of the first color sub-pixel and the third color sub-pixel may be interchanged. In the embodiment of the present disclosure, a green sub-pixel is schematically taken as the second color sub-pixel, but it is not limited thereto; the second color sub-pixel may also be other sub-pixel having the greatest impact on transmittance of the array substrate, or may also be a sub-pixel having the highest power consumption, or may also be a sub-pixel that requires a larger aperture ratio such as a sub-pixel most sensitive to human eyes.

For example, as shown in FIG. 1 to FIG. 3, sizes of sub-pixel regions 1001 of a red sub-pixel (R) and a blue sub-pixel (B) in the first direction (sizes indicated by black arrows in the diagram) may both be 59.45 microns, and a size of the sub-pixel region 1001 of a green sub-pixel (G) in the first direction (a size indicated by a black arrow in the diagram) may be 67.09 microns.

In a case where sub-pixel regions of sub-pixels with respective colors corresponding to the array substrate shown in FIG. 3 all have the same size (e.g., width) in the first direction, a pixel aperture ratio of a red sub-pixel, a pixel aperture ratio of a green sub-pixel, and a pixel aperture ratio of a blue sub-pixel are respectively 13.86%, 13.86% and 13.86%. Transmittance of the array substrate is 3.31% before ACC adjustment and 3.18% after ACC adjustment, decreased by 4%. After resetting pixel aperture ratios of sub-pixels with different colors in a same pixel region by adopting the solution provided by FIG. 3, a pixel aperture ratio of a red sub-pixel, a pixel aperture ratio of a green sub-pixel, and a pixel aperture ratio of a blue sub-pixel are respectively 13.13%, 15.26% and 13.17%, which may perfectly match the characteristics of the color filter and the backlight, and may meet the preset white dot balance coordinates without ACC adjustment. At this time, transmittance is about 3.50%, which may be improved by 10.1% as compared with the above-described transmittance after ACC adjustment.

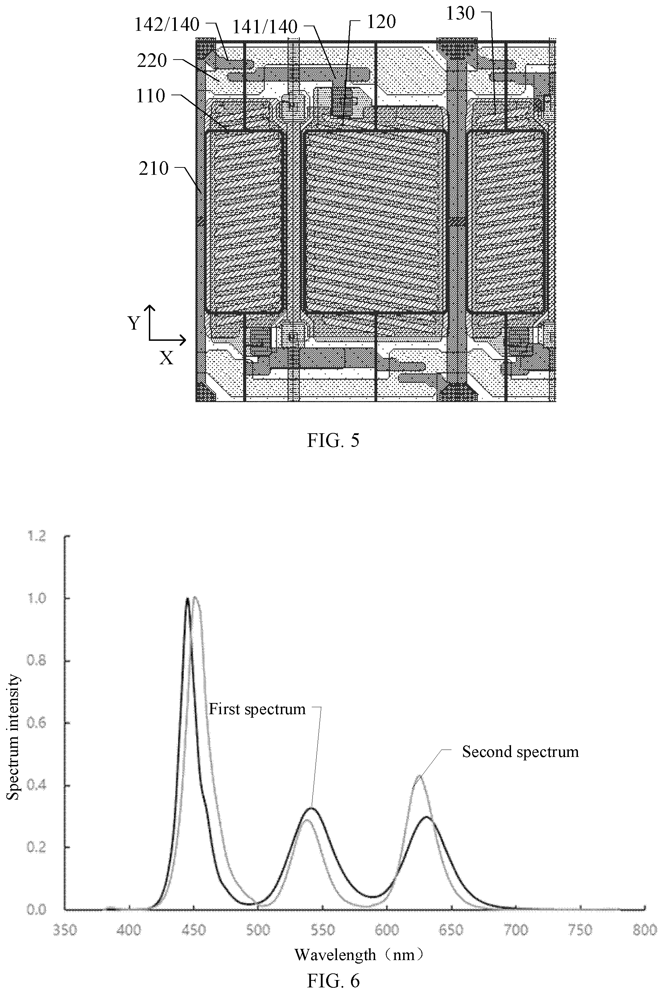

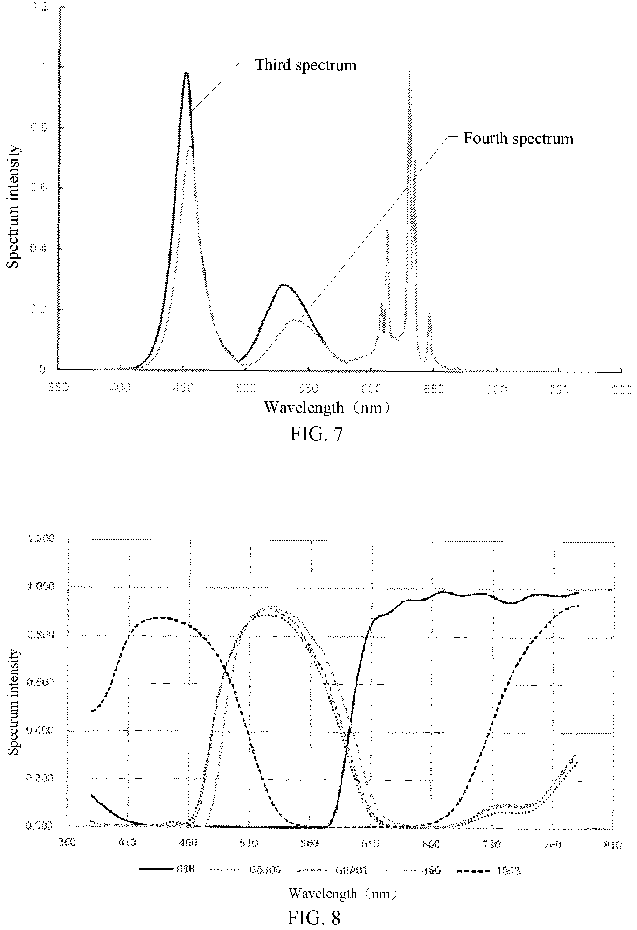

The color filter and the backlight remain unchanged before and after resetting the above-described pixel aperture ratios, for example, the color filter adopts a red light spectrum corresponding to 03R, a green light spectrum corresponding to G6800, and a blue light spectrum corresponding to 100B as shown in FIG. 8; the backlight adopts a quantum dot backlight source, and a spectrum of the quantum dot backlight source is a first spectrum as shown in FIG. 6.

In some examples, as shown in FIG. 1 to FIG. 3, the respective sub-pixels 100 each further include a transistor 140; and a first electrode 141 of the transistor 140 is connected with the pixel electrode 102. For example, the transistor 140 includes a second electrode 142 and a control electrode 143; the second electrode 142 of the transistor 140 is connected with the data line 210; and the control electrode 143 of the transistor 140 is connected with the gate line 220.

In some examples, as shown in FIG. 1 to FIG. 3, in a direction perpendicular to the base substrate 10, the first electrode 141 of the transistor 140 of each sub-pixel 100 overlaps with the common electrode line 230; and an overlapping area between the first electrode 141 of the transistor 140 of the second color sub-pixel 120 and the common electrode line 230 is smaller than overlapping areas between the first electrode 141 of the transistor 140 of sub-pixels with other colors and common electrode lines 230. For example, the sub-pixels with other colors may be a red sub-pixel and a blue sub-pixel. For example, an overlapping area between the first electrode 141 of the transistor 140 of the first color sub-pixel 110 and the common electrode line 230 is equal to an overlapping area between the first electrode 141 of the transistor 140 of the third color sub-pixel 130 and the common electrode line 230.

For example, as compared with the case where sub-pixel regions of respective sub-pixels have the same size in the first direction, in the array substrate provided by the present disclosure, overlapping areas between first electrodes of transistors in the red sub-pixel and in the blue sub-pixel and the common electrode line are increased so that the above-described overlapping area of the green sub-pixel is smaller than the above-described overlapping areas of sub-pixels with other colors.

For example, a ratio of the above-described overlapping area of the transistor in the red sub-pixel to the above-described overlapping area of the transistor in the green sub-pixel is 2 to 2.5.

For example, a charge pull-down voltage of each sub-pixel is: δVp=[Cgs/ (Cgs+Cst+Clc)]*(Vgh-Vgl), where, Cgs is a capacitor between the first electrode (e.g., a source electrode) and the gate electrode of the transistor, Cst is a storage capacitor of the sub-pixel, Clc is a liquid crystal capacitor, Vgh is a potential at which a gate line potential is boosted to a high level, and Vgl is a potential at which a gate line potential is bucked to a low level. The storage capacitor refers to a capacitor between the pixel electrode and the common electrode; and a lateral electric field formed between the pixel electrode and the common electrode passes through a liquid crystal to form the above-described liquid crystal capacitor.

The above-described charge pull-down voltage may refer to that: when period T1 starts, the gate line potential is boosted to Vgh, the transistor is turned on, and positive polarity voltage data Vp transmitted on the data line charges the liquid crystal capacitor and the storage capacitor; when period T1 ends, the gate line potential is bucked to a low level Vgl, and at a moment when the transistor is turned off, the positive polarity voltage data Vp drops δVp, where, δVp is related to the above-described three capacitance values. The value of δVp should not be too great; and a difference in δVp between sub-pixels with different colors should not be too great.

When setting sub-pixel regions of sub-pixels with different colors to have different sizes in the first direction, storage capacitors of sub-pixels with different colors have differences, and further sub-pixels with different colors have different charge pull-down voltages, which is prone to a risk of screen flicker. Therefore, compensation for Cgs and Cst needs to be designed.

By setting an overlapping area between a first electrode of a transistor in a second color sub-pixel having a sub-pixel region with a larger size and a common electrode line to be smaller than an overlapping area between a first electrode of a transistor of a sub-pixel with other color and a common electrode line, it is favorable for improving a storage capacitor of a sub-pixel with other color, and reducing a charge pull-down voltage of a sub-pixel with other color, which may not only minimize a value of δVp as long as layout space allows, but also keep charge pull-down voltages of sub-pixels with different colors substantially consistent, thereby avoiding the risk of screen flicker.

In some examples, as shown in FIG. 1 to FIG. 3, in a same pixel region 20, a ratio of charge pull-down voltages δVp of any two sub-pixels 100 with different colors is 0.9 to 1.1. For example, charge pull-down voltages δVp of any two sub-pixels 100 with different colors are the same.

For example, before compensation, a charge pull-down voltage δVp of a red sub-pixel is 2.58 V, a charge pull-down voltage δVp of a green sub-pixel is 1.83 V, and a charge pull-down voltage δVp of a blue sub-pixel is 2.58 V; after compensation, a charge pull-down voltage δVp of a red sub-pixel is 1.83 V, a charge pull-down voltage δVp of a green sub-pixel is 1.83 V, and a charge pull-down voltage δVp of a blue sub-pixel is 1.83 V. By downregulating a charge pull-down voltage δVp of a red sub-pixel and a charge pull-down voltage δVp of a blue sub-pixel to be equal to a charge pull-down voltage δVp of a green sub-pixel, charge pull-down voltages may be minimized to reduce impact of a gate line voltage switch on a sub-pixel, while making charge pull-down voltages δVp of respective sub-pixels consistent to avoid the risk of screen flicker. For example, the difference of charge pull-down voltages before and after compensation is about 29%.

Size adjustment of sub-pixel regions of sub-pixels with different colors in the first direction may easily cause inconsistent charge pull-down voltages of different sub-pixels, resulting in a screen flicker problem. Although the problem of inconsistent charge pull-down voltages may be alleviated by setting the overlapping area between the first electrode of the transistor and the common electrode line, yet differences of charge pull-down voltages to be adjusted by adjusting the overlapping area have to be ensured within a certain proportion, for example, 35%, in consideration of limitations of layout space, otherwise, charge pull-down voltages of sub-pixels with different colors are hard to become consistent through compensation. Therefore, when adjusting size ratios of sub-pixel regions of sub-pixels with different colors in the first direction, it is also necessary to consider that a difference in charge pull-down voltage before and after compensation should be kept within a certain proportion.

In some examples, as shown in FIG. 1 to FIG. 3, a first portion in the common electrode line 230 that overlaps with the first electrode 141 of the transistor 140 extends along the second direction; a second portion in the common electrode line 230 that is arranged between two columns of sub-pixels 100 is arranged in the same layer as the gate line 220; and the first portion of the common electrode line 230 overlaps with the gate line 220. For example, the first portion of the common electrode line 230 may be arranged in the same layer as a pixel electrode 102.

In some examples, as shown in FIG. 1 to FIG. 3, the first portions of the common electrode lines 230 are alternately arranged with the data lines 210 along the first direction; the first electrode 141 of the transistor 140 is arranged in the same layer as the data line 210; and the first portion of the common electrode line 230 is arranged in the same layer as the pixel electrode 102.

Stack relationships between the common electrode line, the data line, the first electrode of the transistor, and the gate line are set to prevent interference between the common electrode line, the gate line, and the first electrode of the transistor.

In some examples, as shown in FIG. 1 to FIG. 3, a size of an overlapping portion between the first electrode 141 of the transistor 140 of the second color sub-pixel 120 and the first portion of the common electrode line 230 in the second direction is smaller than a size of an overlapping portion between the first electrode 141 of the transistor 140 of the sub-pixel with other color and the first portion of the common electrode line 230 in the second direction. Sizes of overlapping portions between first electrodes of transistors of different sub-pixels and common electrode lines in the second direction are set to adjust an overlapping area of the two.

FIG. 4 is a schematic diagram of some sub-pixels and signal lines in another example shown in FIG. 1. FIG. 5 is a schematic diagram of a partial structure of the sub-pixels and the signal lines shown in FIG. 4. FIG. 6 is a comparison diagram between a spectrum of a backlight source adopted when the array substrate shown in FIG. 2 is applied to a display apparatus and a spectrum of a backlight source adopted when the array substrate shown in FIG. 4 is applied to a display apparatus. FIG. 7 is a spectrogram of another backlight source. FIG. 8 is a comparison diagram between spectrums of different color filters.

The spectrum shown in FIG. 6 may be a spectrum of a quantum dot (QD) backlight source; while the spectrum shown in FIG. 7 may be a spectrum of a fluorescent backlight source.

For example, the backlight source may include a light-emitting chip; the light-emitting chip emits first color light; and a quantum dot material or a fluorescent material is excited by the first color light to emit light of other color. For example, the backlight source may include a variety of quantum dot materials; the light-emitting chip emits blue light; and different quantum dot materials are excited by blue light to emit red light and green light to form white light.

The array substrate in the example shown in FIG. 4 differs from the array substrate shown in FIG. 2 in that: sub-pixel regions of sub-pixels with respective colors have different sizes in the first direction; for example, a size difference of sub-pixel regions of sub-pixels with different colors in the first direction in the array substrate shown in FIG. 4 is greater than a size difference of sub-pixel regions of sub-pixels with different colors in the first direction in the array substrate shown in FIG. 2.

For example, as shown in FIG. 1 to FIG. 5, a size of the pixel region 20 in the first direction may be a certain value, for example, about 186 microns. For example, as shown in FIG. 4, sizes of sub-pixel regions of the red sub-pixel (R) and the blue sub-pixel (B) in the first direction may both be 50.65 microns, while a size of the sub-pixel region of the green sub-pixel (G) in the first direction may be 84.7 microns.

For example, the array substrates shown in FIG. 2 and FIG. 4 may both be applicable to a display apparatus having a 65-inch display screen.

As compared with the array substrate shown in FIG. 2, in the array substrate shown in FIG. 4, sizes of sub-pixel regions of the blue sub-pixel and the red sub-pixel in the first direction are adjusted to be smaller while a size of the sub-pixel region of the green sub-pixel in the first direction is adjusted to be larger, in a case where a size of the pixel region 20 in the first direction is fixed.

For example, as shown in FIG. 4 and FIG. 5, a size ratio of the sub-pixel region of the second color sub-pixel 120 to the sub-pixel region of the first color sub-pixel 110 in the first direction may be 1.67.

Similar to the array substrate shown in FIG. 2, in the array substrates shown in FIG. 4 and FIG. 5, the mode of setting sizes of sub-pixel regions may also lead to differences in storage capacitors of sub-pixels with different colors, and further lead to different charge pull-down voltages for different sub-pixels, which is prone to a risk of screen flicker. Therefore, compensation for Cgs and Cst needs to be designed.

For example, as shown in FIG. 4 and FIG. 5, an overlapping area between the first electrode 141 of the transistor 140 of the second color sub-pixel 120 and the common electrode line 230 is smaller than overlapping areas between first electrodes 141 of transistors 140 of sub-pixels with other colors and common electrode lines 230. For example, sub-pixels with other colors may be the red sub-pixel and the blue sub-pixel. For example, an overlapping area between the first electrode 141 of the transistor 140 of the first color sub-pixel 110 and the common electrode line 230 is equal to an overlapping area between the first electrode 141 of the transistor 140 of the third color sub-pixel 130 and the common electrode line 230.

By setting an overlapping area between the first electrode of the transistor in the second color sub-pixel having the sub-pixel region with a larger size in the first direction and the common electrode line to be smaller than an overlapping area between the first electrode of the transistor of the sub-pixel with other color and the common electrode line, it is favorable for improving a storage capacitor of a sub-pixel with other color, and reducing the charge pull-down voltage, which may keep charge pull-down voltages of sub-pixels with different colors substantially consistent, thereby avoiding the risk of screen flicker.

For example, before compensation, the charge pull-down voltage δVp of the red sub-pixel is 3.829 V, the charge pull-down voltage δVp of the green sub-pixel is 2.48 V, and the charge pull-down voltage δVp of the blue sub-pixel is 3.829 V; after compensation, the charge pull-down voltage δVp of the red sub-pixel is 2.829 V, the charge pull-down voltage δVp of the green sub-pixel is 2.829 V, and the charge pull-down voltage δVp of the blue sub-pixel is 2.829 V. By downregulating charge pull-down voltages δVp of the red sub-pixel and the blue sub-pixel to 2.829 V, and upregulating the charge pull-down voltage δVp of the green sub-pixel to 2.829 V, the charge pull-down voltages may be minimized, while making charge pull-down voltages δVp of respective sub-pixels consistent to avoid the risk of screen flicker. For example, differences in charge pull-down voltages of the red sub-pixel and the blue sub-pixel before and after compensation are about 26%, while a difference in charge pull-down voltage of the green sub-pixel before and after compensation is about 14%.

Size adjustment of sub-pixel regions of sub-pixels with different colors in the first direction may easily cause inconsistent charge pull-down voltages of different sub-pixels, resulting in a screen flicker problem. Although the problem of inconsistent charge pull-down voltages may be alleviated by setting an overlapping area between the first electrode of the transistor and the common electrode line, yet differences of charge pull-down voltages to be adjusted by adjusting the overlapping area have to be ensured within a certain proportion, for example, 35%, in consideration of limitations of layout space, otherwise, charge pull-down voltages of sub-pixels with different colors are hard to become consistent through compensation. Therefore, when adjusting size ratios of sub-pixel regions of sub-pixels with different colors in the first direction, it is also necessary to consider that a difference in charge pull-down voltage before and after compensation should be kept within a certain proportion.

For example, a size of an overlapping portion between the first electrode 141 of the transistor 140 of the green sub-pixel 120 and the common electrode line 230 in the second direction in the array substrate shown in FIG. 3 is a first width; a size of an overlapping portion between the first electrode 141 of the transistor 140 of the green sub-pixel 120 and the common electrode line 230 in the second direction in the array substrate shown in FIG. 5 is a second width; and the first width is greater than the second width. A size of an overlapping portion between the first electrode 141 of the transistor 140 of the blue sub-pixel 130 and the common electrode line 230 in the second direction in the array substrate shown in FIG. 3 is a third width; a size of an overlapping portion between the first electrode 141 of the transistor 140 of the blue sub-pixel 130 and the common electrode line 230 in the second direction in the array substrate shown in FIG. 5 is a fourth width; and the third width is less than the fourth width.

In the case where sub-pixel regions of sub-pixels with respective colors corresponding to the array substrate shown in FIG. 5 all have a same size (e.g., width) in the first direction, a pixel aperture ratio of the red sub-pixel, a pixel aperture ratio of the green sub-pixel, and a pixel aperture ratio of the blue sub-pixel are respectively 13.86%, 13.86% and 13.86%. Transmittance of the array substrate is 3.31% before ACC adjustment and 3.18% after ACC adjustment, decreased by 4%.

After resetting pixel aperture ratios of sub-pixels with different colors in the same pixel region by adopting the solution provided by FIG. 5, a pixel aperture ratio of the red sub-pixel, a pixel aperture ratio of the green sub-pixel, and a pixel aperture ratio of the blue sub-pixel are respectively 10.78%, 20.00% and 10.78%; the pixel aperture ratios of the above-described sub-pixels with respective colors match the second spectrum of the backlight source shown in FIG. 6 and the spectrum of the color filter shown in FIG. 8, for example, the color filter adopts a red light spectrum corresponding to 03R, a green light spectrum corresponding to 46G, and a blue light spectrum corresponding to 100B.

For example, as compared with the first spectrum adopted by the backlight source corresponding to the array substrate shown in FIG. 2, spectrum intensities and peak positions of red light, green light and blue light in the second spectrum shown in FIG. 6 adopted by the backlight source corresponding to the array substrate shown in FIG. 4 are adjusted. For example, as shown in FIG. 6, the second spectrum of the backlight source includes a red light peak, a green light peak and a blue light peak; a peak value of the red light peak is higher than a peak value of the green light peak. The peak values of the above-described peaks are just the spectrum intensities shown in FIG. 6. For example, spectrum intensities of blue light peaks in the first spectrum and the second spectrum are equivalent, and the blue light peak in the second spectrum is shifted towards a longwave direction by a certain distance relative to the blue light peak in the first spectrum. For example, a spectrum intensity of the green light peak in the second spectrum is less than a spectrum intensity of the green light peak in the first spectrum, and the green light peak in the second spectrum is shifted towards a shortwave direction by a certain distance relative to the green light peak in the first spectrum. For example, a spectrum intensity of the red light peak in the second spectrum is greater than a spectrum intensity of the red light peak in the first spectrum, and the red light peak in the second spectrum is shifted towards the shortwave direction by a certain distance relative to the red light peak in the first spectrum. For example, a ratio of the peak value of the blue light peak to the peak value of the red light peak is 1.8 to 2.8. For example, a ratio of the peak value of the blue light peak to the peak value of the red light peak is 2 to 2.6. For example, a ratio of the peak value of the blue light peak to the peak value of the red light peak is 2.3 to 2.5.

For example, compared with the color film corresponding to the array substrate shown in FIG. 2, the color film corresponding to the array substrate shown in FIG. 4 adjusts the spectral intensity and peak position of green light. For example, as shown in FIG. 8, a spectrum intensity of green light of the color filter corresponding to the array substrate shown in FIG. 4 is greater than a spectrum intensity of green light of the color filter corresponding to the array substrate shown in FIG. 2; a peak of green light of the color filter corresponding to the array substrate shown in FIG. 4 is shifted towards the longwave direction by a certain distance relative to a peak value of green light of the color filter corresponding to the array substrate shown in FIG. 2.

Through the above-described adjustment of the backlight spectrum and the color filter spectrum, solutions of the pixel aperture ratio, the color filter and the backlight may be perfectly matched to meet the preset white dot balance coordinates with transmittance of about 4.49% without ACC adjustment. As compared with the solution in which pixel aperture ratios of different sub-pixels are the same and ACC adjustment is needed, the array substrate shown in FIG. 4 may have transmittance increased by about 41%, after combining with the second spectrum feature of the backlight source shown in FIG. 6 and the color filter including the green light spectrum corresponding to 46G shown in FIG. 8.

Thus, on the premise of meeting other specifications such as color gamut, in combination with the adjusted backlight and the adjusted color filter, size differences between effective light-exiting regions of sub-pixels with different colors in the array substrate in the first direction may be further increased, and at this time, transmittance may be increased by more than 30%.

FIG. 7 is a spectrogram of another backlight source. The spectrum shown in FIG. 7 may be a spectrum of a fluorescent backlight source. For example, the fluorescent backlight source may include potassium fluorosilicate (KSF). KSF fluorescent powder is red fluorescent powder. A fourth spectrum shown in FIG. 7 is a spectrum adjusted on the basis of the third spectrum to adapt to the pixel aperture ratio of the present application. The fourth spectrum mainly has spectrum intensities and peak positions of blue light and green light adjusted, without adjusting a spectrum of red light.

Based on the case where the pixel aperture ratio of the red sub-pixel, the pixel aperture ratio of the green sub-pixel and the pixel aperture ratio of the blue sub-pixel in the array substrate shown in FIG. 5 are respectively 10.78%, 20.00% and 10.78%, a spectrum of the backlight source is adjusted, for example, to the fourth spectrum shown in FIG. 7; meanwhile, a spectrum of the color filter is adjusted accordingly; the color filter adopts the red light spectrum corresponding to 03R, the green light spectrum corresponding to GBA01, and the blue light spectrum corresponding to 100B shown in FIG. 8.

For example, as shown in FIG. 7, the fourth spectrum includes a red light peak, a green light peak and a blue light peak; a ratio of a peak value of the blue light peak to a value of the red light peak is 0.7 to 0.9; and a ratio of a peak value of the green light peak to the peak value of the red light peak is 0.15 to 0.28. For example, a spectrum intensity of the blue light peak in the fourth spectrum is less than a spectrum intensity of the blue light peak in the third spectrum; and the blue light peak in the fourth spectrum shifts towards the longwave direction by a certain distance relative to the blue light peak in the third spectrum. For example, a spectrum intensity of the green light peak in the fourth spectrum is less than a spectrum intensity of the green light peak in the third spectrum; and the green light peak in the fourth spectrum shifts towards the longwave direction by a certain distance relative to the green light peak in the third spectrum.

For example, the fourth spectrum includes the red light peak, the green light peak and the blue light peak; the ratio of the peak value of the blue light peak to the peak value of the red light peak is 0.75 to 0.85; and the ratio of the peak value of the green light peak to the peak value of the red light peak is 0.18 to 0.25. For example, the fourth spectrum includes the red light peak, the green light peak and the blue light peak; the ratio of the peak value of the blue light peak to the peak value of the red light peak is 0.78 to 0.8; and the ratio of the peak value of the green light peak to the peak value of the red light peak is 0.2 to 0.23.

By adjusting the pixel aperture ratio, the spectrum of the backlight source, and the spectrum of the color filter, solutions of the pixel aperture ratio, the color filter and the backlight may be perfectly matched to meet white spot Spec without ACC, which enhances transmittance, for example, the transmittance is about 4.14%, and the transmittance may be increased by about 30%.

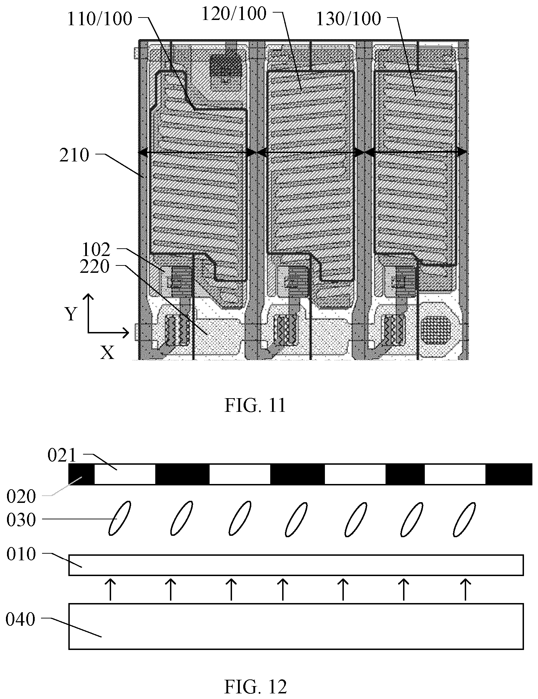

FIG. 9 is a schematic diagram of a partial structure of an array substrate provided by another example of the embodiment of the present disclosure. FIG. 10 is a schematic diagram of the sub-pixels shown in FIG. 9 before adjusting a size of a sub-pixel region. FIG. 11 is a schematic diagram of the sub-pixels shown in FIG. 9 after adjusting a size of the sub-pixel region.

The array substrate shown in FIG. 9 differs from the array substrate shown in FIG. 1 in that the array substrate shown in FIG. 9 adopts a single gate design.

In some examples, as shown in FIG. 9 to FIG. 11, each pixel region 20 includes a first color sub-pixel 110, a second color sub-pixel 120 and a third color sub-pixel 130; in a same pixel region 20, a pixel electrode 102 of the first color sub-pixel 110 has the largest size in the first direction.

In some examples, as shown in FIG. 9 to FIG. 11, in the first direction, a size of a pixel electrode 102 of the second color sub-pixel 120 is larger than a size of a pixel electrode 102 of the third color sub-pixel 130; a difference between the pixel electrode 102 of the first color sub-pixel 110 and the pixel electrode 102 of the second color sub-pixel 120 is a first difference; a difference between the pixel electrode 102 of the second color sub-pixel 120 and the pixel electrode 102 of the third color sub-pixel 130 is a second difference; and a ratio of the first difference to the second difference is 0.9 to 1.1. For example, the first difference is the same as the second difference.

In some examples, as shown in FIG. 9 to FIG. 11, the plurality of data lines 210 is unevenly distributed in the first direction; and the plurality of gate lines 220 is evenly distributed in the second direction.

For example, as shown in FIG. 10, before adjusting sizes of sub-pixel regions of sub-pixels with respective colors in the first direction, the sizes of the sub-pixel regions of the sub-pixels with respective colors in the first direction (the sizes as indicated by black double arrows in FIG. 10) are all the same, for example, all are 62 microns. Pixel aperture ratios of a red sub-pixel 110, a green sub-pixel 120 and a blue sub-pixel in the array substrate shown in FIG. 10 are respectively 11.97%, 16.53% and 14.51%. After matching the array substrate shown in FIG. 10 with the first spectrum of the backlight source shown in FIG. 6 and the color filter shown in FIG. 8 (including the red light spectrum corresponding to 03R, the green light spectrum corresponding to G6800, and the blue light spectrum corresponding to 100B), white light emitted will not meet the preset white dot balance coordinates if no ACC adjustment is performed. Therefore, ACC adjustment is required, and transmittance after ACC adjustment is respectively 3.74% and 3.30%.

For example, as shown in FIG. 11, after adjusting sizes of sub-pixel regions of sub-pixels with respective colors in the first direction, the sizes of the sub-pixel regions of the red sub-pixel 110, the green sub-pixel 120, and the blue sub-pixel 130 in the first direction (indicated by black double arrows in the diagram) are respectively 68 microns, 60 microns and 58 microns. The pixel aperture ratios of the red sub-pixel 110, the green sub-pixel 120 and the blue sub-pixel 130 are respectively 13.20%, 15.48% and 13.60%; the array substrate shown in FIG. 11 may perfectly match the first spectrum of the backlight source shown in FIG. 6 and the color filter shown in FIG. 8 (including the red light spectrum corresponding to 03R, the green light spectrum corresponding to G6800, and the blue light spectrum corresponding to 100B) to make emitted white light meet the preset white dot balance coordinates without ACC adjustment, and at this time, transmittance is 3.61%, which is increased by 9.4% as compared with that in the solution shown in FIG. 10.

For example, in the array substrate shown in FIG. 11, the design similar to that in FIG. 3 and FIG. 5 as described above may be adopted, for example, the capacitor Cst is compensated to make charge pull-down voltages of sub-pixels with different colors consistent.

For example, the array substrate shown in FIG. 11 may also have transmittance further improved by matching the backlight source and the color filter having other spectrums as described above.

FIG. 12 is a schematic diagram of a partial structure of a display apparatus provided by another embodiment of the present disclosure. As shown in FIG. 12, the display apparatus includes an array substrate 010, an opposite substrate 020, a liquid crystal layer 030, and a backlight source 040. The opposite substrate 020 is arranged opposite to the array substrate 010, and the opposite substrate 020 includes a color filter 021; the liquid crystal layer 030 is located between the array substrate 010 and the opposite substrate 020; the backlight source 040 is located on a side of the array substrate 010 away from the liquid crystal layer 030. A size ratio of effective light-exiting regions of at least two sub-pixels with different colors in a pixel region in the first direction is 1 to 2, so that white light emitted by the display apparatus meets the preset white balance coordinates without performing accurate color capture adjustment on the display apparatus.

The array substrate included in the display apparatus may be the array substrate in any one of the above-described examples. The backlight source included in the display apparatus may be the backlight source having the above-described spectrum shown in FIG. 6 to FIG. 7, for example, the quantum dot backlight source or the fluorescent backlight source. The color filter included in the display apparatus may be the above-described color filter having the spectrum shown in FIG. 8.

The display apparatus provided by the present disclosure may increase transmittance of the display apparatus by at least 10%, for example, by more than 30%, on the premise of meeting white balance, by adjusting the spectrum of the color filter, the spectrum of the backlight source, and sizes of sub-pixel regions of sub-pixels in the first direction.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. An array substrate, comprising:
a base substrate;
a plurality of sub-pixels, located on the base substrate and arranged in an array along a first direction and a second direction; the first direction and the second direction intersecting with each other;
wherein the array substrate comprises a plurality of pixel regions, each pixel region comprises sub-pixels with different colors arranged along the first direction, and different pixel regions have a same area;
in a same pixel region, sub-pixel regions of at least two sub-pixels with different colors have different sizes in the first direction; a size ratio of the sub-pixel regions of the at least two sub-pixels with different colors in the first direction ranges from 1 to 2; and the sub-pixel region comprises an effective light-exiting region.

2. The array substrate according to claim 1, further comprising:
a plurality of data lines, arranged along the first direction; and
a plurality of gate lines, arranged along the second direction,
wherein the plurality of data lines and the plurality of gate lines intersect with each other to surround effective light-exiting regions of the plurality of sub-pixels.

3. The array substrate according to claim 2, wherein respective sub-pixels each comprise a pixel electrode and a common electrode stacked; and in a same pixel region, pixel electrodes of the at least two sub-pixels with different colors have different sizes in the first direction.

4. The array substrate according to claim 2 or 3, wherein the plurality of data lines is unevenly distributed in the first direction, and the plurality of gate lines is evenly distributed in the second direction.

5. The array substrate according to claim 4, wherein a size ratio of pixel electrodes of the at least two sub-pixels with different colors in the first direction is not greater than 2.

6. The array substrate according to any one of claims 1 to 5, wherein, in a same pixel region, a size ratio of sub-pixel regions of the at least two sub-pixels with different colors in the second direction ranges from 0.9 to 1.1.

7. The array substrate according to claim 3, wherein each pixel region comprises a first color sub-pixel, a second color sub-pixel, and a third color sub-pixel; and in a same pixel region, a sub-pixel region of the second color sub-pixel has the largest size in the first direction.

8. The array substrate according to claim 7, wherein the pixel electrode of the second color sub-pixel has the largest size in the first direction.

9. The array substrate according to claim 7 or 8, wherein, in a same pixel region, a size ratio of a sub-pixel region of the first color sub-pixel to a sub-pixel region of the third color sub-pixel in the first direction ranges from 0.9 to 1.1.

10. The array substrate according to claim 9, wherein, in a same pixel region, a size ratio of the pixel electrode of the first color sub-pixel to the pixel electrode of the third color sub-pixel in the first direction ranges from 0.9 to 1.1.

11. The array substrate according to any one of claims 7 to 10, wherein respective sub-pixels each further comprise a transistor; and a first electrode of the transistor is connected with a pixel electrode;
the array substrate further comprises a common electrode line electrically connected with a common electrode; in a direction perpendicular to the base substrate, the first electrode of the transistor of each sub-pixel overlaps with the common electrode line; and an overlapping area between the first electrode of the transistor of the second color sub-pixel and the common electrode line is smaller than an overlapping area between the first electrode of the transistor of a sub-pixel with other color and the common electrode line.

12. The array substrate according to claim 11, wherein, in a same pixel region, a ratio of charge pull-down voltages δVp of any two sub-pixels with different colors ranges from 0.9 to 1.1; δVp=[Cgs/(Cgs+Cst+Clc)]*(Vgh-Vgl), where, Cgs is a capacitor between the first electrode and a gate electrode of the transistor, Cst is a storage capacitor of a sub-pixel, Clc is a liquid crystal capacitor, Vgh is a potential at which a gate line potential is boosted to a high level, and Vgl is a potential at which a gate line potential is bucked to a low level.

13. The array substrate according to claim 11 or 12, wherein a first portion in the common electrode line that overlaps with the first electrode of the transistor extends along the second direction; and a size of an overlapping portion between the first electrode of the transistor of the second color sub-pixel and the first portion in the second direction is smaller than a size of an overlapping portion between the first electrode of the transistor of the sub-pixel with other color and the first portion in the second direction.

14. The array substrate according to claim 12, wherein the first portion of the common electrode line is alternately arranged with the data line along the first direction; the first electrode of the transistor is arranged in the same layer as the data line; and the first portion is arranged in the same layer as the pixel electrode.

15. The array substrate according to claim 13, wherein the plurality of sub-pixels is arranged into a plurality of rows and columns of sub-pixels; sub-pixels located in a same row are arranged in the first direction, while sub-pixels located in a same column are arranged in the second direction; two gate lines are arranged between two adjacent rows of sub-pixels; and two columns of sub-pixels are arranged between two adjacent data lines;
a second portion of the common electrode line that is arranged between the two columns of sub-pixels is arranged in the same layer as the gate line; and the first portion of the common electrode line overlaps with the gate line.

16. The array substrate according to claim 15, wherein two gate lines constitute a gate line pair; the plurality of gate lines comprises a plurality of gate line pairs; and the plurality of gate line pairs is evenly distributed in the second direction.

17. The array substrate according to claim 3 or 4, wherein each pixel region comprises a first color sub-pixel, a second color sub-pixel, and a third color sub-pixel; and in a same pixel region, the pixel electrode of the first color sub-pixel has the largest size in the first direction.

18. The array substrate according to claim 17, wherein, in the first direction, a size of the pixel electrode of the second color sub-pixel is larger than a size of the pixel electrode of the third color sub-pixel; a difference between the pixel electrode of the first color sub-pixel and the pixel electrode of the second color sub-pixel is a first difference; a difference between the pixel electrode of the second color sub-pixel and the pixel electrode of the third color sub-pixel is a second difference; and a ratio of the first difference to the second difference ranges from 0.9 to 1.1.

19. The array substrate according to claim 17 or 18, wherein the plurality of sub-pixels is arranged into a plurality of rows and columns of sub-pixels; sub-pixels located in a same row are arranged in the first direction, while sub-pixels located in a same column are arranged in the second direction; one gate line is arranged between two adjacent rows of sub-pixels, and one data line is arranged between two adjacent columns of sub-pixels.

20. The array substrate according to any one of claims 7 to 19, wherein the first color sub-pixel is a red color sub-pixel, the second color sub-pixel is a green sub-pixel, and the third color sub-pixel is a blue sub-pixel.

21. A display apparatus, comprising:
the array substrate according to any one of claims 1 to 20;
an opposite substrate, arranged opposite to the array substrate, the opposite substrate comprising a color filter;
a liquid crystal layer, located between the array substrate and the opposite substrate; and
a backlight source, located on a side of the array substrate away from the liquid crystal layer,
wherein a size ratio of sub-pixel regions of the at least two sub-pixels with different colors in the pixel region in the first direction ranges from 1 to 2, so that white light emitted by the display apparatus meets preset white balance coordinates without performing accurate color capture adjustment on the display apparatus.

22. The display apparatus according to claim 21, wherein the backlight source comprises a quantum dot material or a fluorescent material.

23. The display apparatus according to claim 22, wherein the backlight source comprises a quantum dot material; a spectrum of the backlight source comprises a red light peak, a green light peak and a blue light peak; and a peak value of the red light peak is higher than a peak value of the green light peak.

24. The display apparatus according to claim 23, wherein a ratio of a peak value of the blue light peak to the peak value of the red light peak ranges from 1.8 to 2.8.

25. The display apparatus according to claim 22, wherein the backlight source comprises a fluorescent material; and a spectrum of the backlight source comprises a red light peak, a green light peak, and a blue light peak; a ratio of a peak value of the blue light peak to a peak value of the red light peak ranges from 0.7 to 0.9; and a ratio of a peak value of the green light peak to the peak value of the red light peak ranges from 0.15 to 0.28.
